(19) **Europäisches Patentamt / European Patent Office / Office européen des brevets**

(11) **EP 2 485 238 A1**

(12) **EUROPEAN PATENT APPLICATION**
published in accordance with Art. 153(4) EPC

(43) Date of publication:
**08.08.2012 Bulletin 2012/32**

(21) Application number: **10820444.7**

(22) Date of filing: **24.09.2010**

(51) Int Cl.:
**H01J 1/304** (2006.01)　　　**H01J 37/073** (2006.01)

(86) International application number:
**PCT/JP2010/066534**

(87) International publication number:
**WO 2011/040326 (07.04.2011 Gazette 2011/14)**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **29.09.2009 JP 2009224337**

(71) Applicant: **Denki Kagaku Kogyo Kabushiki Kaisha Tokyo 103-8338 (JP)**

(72) Inventor: **MORISHITA Toshiyuki**
**Shibukawa-city**
**Gunma 377-8520 (JP)**

(74) Representative: **Potter, Julian Mark**
**WP Thompson**
**55 Drury Lane**
**London WC2B 5SQ (GB)**

(54) **ROD FOR ELECTRON SOURCE, ELECTRON SOURCE, AND ELECTRONIC APPLIANCE**

(57) The object of the invention is to provide an electron source that operates at lower temperature and has a low work function having a smaller energy width.

An electron source, comprising an electrical porcelain, two conductive terminals connected to the electrical porcelain, a filament formed as it extends between the conductive terminals, and a rod of the <100> single crystal of at least one metal selected from the group consisting of tungsten, molybdenum, tantalum and rhenium, connected to the filament, wherein: the rod has an electron-emitting face formed in the tip region with its {100} crystal face exposed; the rod has a diffusion source on the central region; the diffusion source is made of a mixed oxide of barium oxide group and scandium oxide; and the compositional rate of barium oxide group as BaO is 50 mol % or more and that of scandium oxide as $Sc_2O_3$ 10 to 50 mol % when the mixed oxide is prepared.

[Fig.1]

**Description**

Technical Field

The present invention relates to an electron source emitting electron beam, an electron-source rod connected thereto, and an electronic device using the electron source.

Background Art

Schottky electron emission sources using a needle-shaped electrode of tungsten single crystal have been used recently for emission of an electron beam that has a longer life and is brighter than that from hot cathodes. The electron source, which has a single-crystal tungsten rod with its <100> direction in parallel with the axial direction and a coating layer of zirconium and oxygen (hereinafter, referred to as ZrO coating layer) formed thereon, the ZrO coating layer reducing the work function of the tungsten (100) single crystal from 4.5 eV to approximately 2.8 eV, is characteristic in that the electron beam obtained is brighter and longer-lasting than conventional hot cathodes, because only the microcrystal face corresponding to the (100) face formed on the sharpened tip of the rod functions as the electron emission region. The electron source (hereinafter, referred to as "ZrO/W electron source") is also characteristic in that it is more stable than cold field emission cathodes, can operate even at low vacuum degree and is thus easier in handling.

In the ZrO/W electron source, an electron beam-emitting needle-shaped single-crystal tungsten <100> rod is connected, for example by welding, to a particular position of a tungsten filament formed on a conductive terminal fixed to an electrical porcelain. The single-crystal rod has a sharpened tip formed by electrolytic polishing, which functions as the electron-emitting unit. A diffusion source of zirconium and oxygen (zirconium oxide) is formed on part of the single-crystal rod. Alternatively, the surface of the single-crystal rod is covered with a ZrO coating layer.

Because the single-crystal rod is used normally at a temperature of about 1800K, as it is heated electrically by the filament, the ZrO coating layer on the single-crystal rod surface disappears gradually by vaporization. Thus, a diffusion source containing ZrO is formed in the electron source. The presence of the ZrO-containing diffusion source allows diffusion and continuous supply of the zirconium and oxygen therefrom to the surface of the single-crystal rod for preservation of the ZrO skin layer.

Such ZrO/W electron sources, which has higher brightness and longer life, have been used widely, for example in scanning electron microscopes, transmission electron microscopes, surface analyzers such as Auger electron spectrometers, semiconductor-processing electron-beam devices, electron-beam exposure devices and the like. Because test samples are analyzed and measured as they are in these devices, a low-acceleration electron beam at 1Kv or less is generally used.

When such a low-acceleration electron beam is used, the diameter of the electron beam focused by an electrostatic or magnetic field lens is governed by color aberration (see Nonpatent Document 1).

For reduction of the color aberration, it is needed to decrease the energy width of the electrons emitted from the electron source. The energy width of the electron beam from a Schottky electron emitter is not lower than 2.45 kB at the lowest. Here, $k_B$ is the Boltzmann constant and T is the absolute temperature of the electron emission region (see Nonpatent Document 2).

Although it is effective to decrease the temperature of electron source for reduction of color aberration, the decrease in operating temperature results in Schottky electron elution and drastic decrease of the emission current during thermal electron emission.

For that reason, there is a demand for an electron source having a lower work function for reduction of the temperature of the electron source and screening for diffusion sources to be installed in such an electron source are intensively under progress.

For example, Patent Document 1 discloses an electron source containing barium aluminate ($BaAl_2O_4$) as supply source (Patent Document 1). Alternatively, Patent Document 2 discloses electron sources containing $Pr_2O_3$, $Ho_2O_3$, $Gd_2O_3$, $Nd_2O_3$ or $Sm_2O_3$ as diffusion source.

However, electron sources and devices using such an electron source that operate at lower temperature and have a low work function having a smaller energy width are desired.

Citation List

Patent Document

[Patent Document 1] Japanese Unexamined Patent Application Publication No. 2005-222945

[Patent Document 2] Japanese Unexamined Patent Application Publication No. 2008-098087

Non-Patent Document

[Nonpatent Document 1] J. Pawley, 'Journal of Microscopy', 136, Pt1, 45 (1984)
[Nonpatent Document 2] R. D. Young, 'Phys. Rev.', 113 (1959) p.110

Summary of Invention

Technical Problem

An object of the present invention is to provide an electron source that operates at low temperature and has a low work function having a smaller energy width, an electron-source rod for use therein and a device using the electron source.

Solution to Problem

After intensive studies on electron sources with various diffusion sources under the circumstances above, the inventors have found that it is possible to obtain an electron source that operates at lower temperature and has a low work function having a smaller energy width than electron sources with conventional metal oxides by using a mixed oxide containing barium oxide group and scandium oxide at a particular blending rate as the diffusion source of the electron source, and achieved the present invention.

Specifically to solve the problems above, the present invention provides an electron source, comprising an electrical porcelain, two conductive terminal connected to the electrical porcelain, a filament formed as it extends between the conductive terminals, and a rod of the <100> single crystal of at least one metal selected from the group consisting of tungsten, molybdenum, tantalum and rhenium, which is connected to the filament, wherein the rod has an electron-emitting face formed in the tip region with its {100} crystal face exposed, the rod has a diffusion source on the central region, the diffusion source is made of a mixed oxide of barium oxide group and scandium oxide, and the compositional rate of barium oxide group as BaO is 50 mol % or more and that of scandium oxide as $Sc_2O_3$ 10 to 50 mol % when the mixed oxide is prepared.

Low barium oxide group compositional rate tends to result in low volatility of the diffusion source, while high barium oxide group rate tends to result in high volatility thereof. Thus, low compositional rate of scandium oxide, which is used in combination, tends to result in high volatility, while high scandium oxide rate tends to result in low volatility.

The operating temperature of the electron source is preferably 900K or more and 1250K or less, and the barium oxide group is preferably $BaCO_3$.

The present invention also provides an electron-source rod, formed with the <100> single crystal of at least one metal selected from the group consisting of tungsten, molybdenum, tantalum and rhenium, comprising an electron-emitting face exposing the {100} crystal face in the tip region and a diffusion source of a mixed oxide prepared by heat treatment of a mixture containing barium oxide group and scandium oxide at a molar ratio of barium oxide group (as BaO): scandium oxide (as $Sc_2O_3$) of 1:1 to 3:2 on the central region of the rod.

The mixture preferably contains barium oxide group and scandium oxide at a barium oxide group compositional rate (as BaO) of 50 to 90 mol % and a scandium oxide compositional rate (as $Sc_2O_3$) of 10 to 50 mol %, with respect to 100 mol % of the sum of the amounts as BaO and $Sc_2O_3$.

The present invention also provides an electronic device, including the electron-source or including an electron source containing the electron-source rod. Favorable electronic devices include scanning electron microscopes, transmission electron microscopes, surface analyzers, semiconductor-processing electron-beam devices and electron-beam exposure devices.

Advantageous Effect of Invention

An electron source according to the present invention can operate at lower operating temperature for an extended period of time. It can also operate reliably at high angular current density and at high probability for an extended period of time.

The electronic device according to the present invention can also improve the resolution of scanning electron microscopes and semiconductor-processing electron-beam devices, allow fine patterning by electron beam exposure devices, and improve the sensitivity of transmission electron microscopes.

Brief Description of Drawings

[Fig. 1] Fig. 1 is a view showing the configuration of an electron source.
[Fig. 2] Fig. 2 is a view showing formation of a diffusion source by application of a slurry on a part of a rod.
[Fig. 3] Fig. 3 is a chart showing the configuration of an evaluation instrument used for measurement of electron-emitting properties.
[Fig. 4] Fig. 4 is a graph showing a temperature dependence of an effective work function of a ZrO/W electron source and an electron source having a diffusion source of a mixed oxide of barium and scandium oxides.
[Fig. 5] Fig. 5 is a graph showing a relationship between the angular current density $Ip/\omega$ and the emitter voltage of a ZrO/W electron source and an electron source having a diffusion source of a mixed oxide of barium and scandium oxides.

Description of Embodiments

Hereinafter, favorable embodiments of the present invention will be described with reference to drawings. The embodiments described below are only typical embodiments of the present invention and the present invention shall not be construed narrower in its scope.

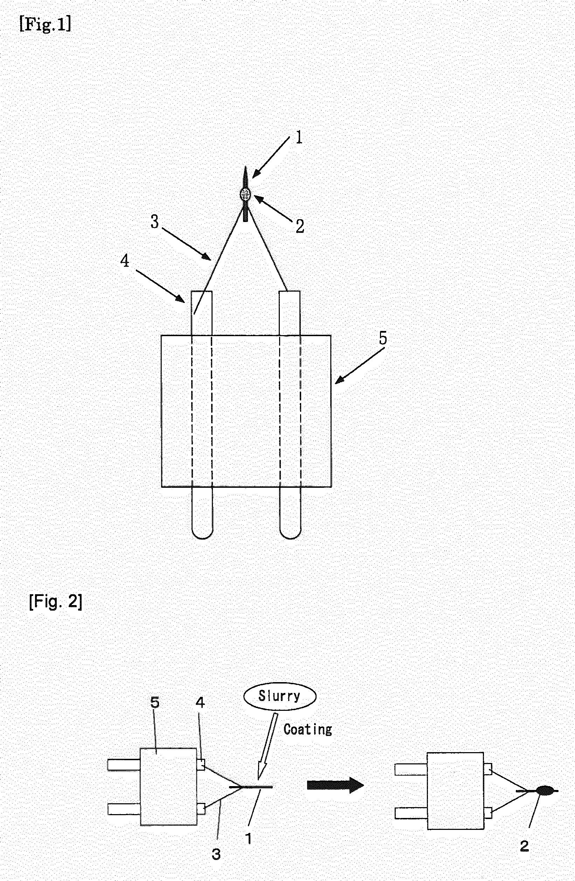

The electron source according to the present invention is a rod of the single crystal in the <100> direction of a particular metal, at least including an electron-source rod having an electron-emitting face formed in the tip region as the {100} crystal face exposed, and a mixed metal oxide containing barium oxide group and scandium oxide at a particular compositional rate as the diffusion source on the central region.
For example as shown in Fig. 1, the electron source preferably has an electrical porcelain 5, two conductive terminals 4 and 4 connected to the electrical porcelain 5, filaments 3 and 3 formed as they extend between the conductive terminals 4 and 4, a rod 1 connected to the filaments 3 and 3, and a diffusion source 2 formed on the central region of the rod 1.

The electron-source rod is a rod of the <100> single crystal of a particular metal, which has an electron-emitting face with its {100} crystal face exposed in the tip region and a diffusion source of a mixed metal oxide formed by heat treatment of barium oxide group and scandium oxide at a particular compositional rate (molar ratio) formed on the central region.

The particular metal is at least one metal selected from the group consisting of tungsten, molybdenum, tantalum and rhenium. In particular, tungsten and/or molybdenum is preferable from the point of processability

The constituent materials blended for preparation of the mixed oxide by heat treatment are barium oxide group and scandium oxide. Constituent materials (metal elements) other than those above may be contained, if the advantageous effects of the present invention are not impaired, but the other constituent materials are desirably not contained practically in the constituent materials.

The barium oxide group is not particularly limited, and BaO or any other compound that gives BaO under heat can be used favorably. For example, the barium oxide group is one or more compounds selected from barium oxide group (BaO), barium carbonate ($BaCO_3$), barium acetate, barium borate, barium oxalate, barium sulfate and the like. In particular, barium oxide group (BaO) and/or barium carbonate ($BaCO_3$) are preferable, and barium carbonate ($BaCO_3$) is more preferable, because it can react with other metal oxides in solid phase.
Alternatively, the scandium oxide is, for example, the compound represented by $Sc_2O_3$. Scandium oxide has not been used, because it does not show electron-emitting properties better than ZrO/W electron sources, but, in the present invention, it provided an advantageous effect, when used in combination with barium oxide group, that the electron source thereof is likely to operate at lower operating temperature for an extended period of time.

The molar ratio of the barium oxide group (as BaO) to the scandium oxide (as $Sc_2O_3$) when blended for preparation of the mixed oxide by heat treatment is preferably 1:1 to 3:2, more preferably 3:2.

As for the compositional rate of the barium oxide group and the scandium oxide, as described above, BaO or the barium oxide group precursor giving BaO under heat is preferably contained in an amount of 50 to 90 mol % as BaO and scandium oxide in an amount of 50 to 10 mol % as $Sc_2O_3$, with respect to 100 mol % of the sum of the amounts as BaO and $Sc_2O_3$. It is possible to obtain an electron source showing favorable electron-emitting properties when the rate is in the range above. Thus, an electron source using the same can operate at lower operating temperature and also for an extended period of time. More preferably, the barium oxide group is contained in an amount of 50 to 70 mol % and the scandium oxide in an amount of 50 to 30 mol %, and particularly preferably, the barium oxide group is contained in an amount of 50 to 60 mol % and the scandium oxide in an amount of 50 to 40 mol %. It is thus possible to obtain an electron source that operates at lower operating temperature for an extended period of time.

As described above, the mixed metal oxide used as the diffusion source is a sintered mixed metal oxide of barium oxide group and scandium oxide formed by heat treatment of a mixture obtained by mixing barium oxide group

and scandium oxide ($Sc_2O_3$) at a particular molar ratio (compositional rate).

For preparation of an electron source superior in electron-emitting properties, the heat treatment condition then is preferably 1100 to 1300°C for 40 to 60 hours in air (approximately 1 atmospheric pressure).

An embodiment of the electron-source rod (electron source) according to the present invention will be described below, but it is to be appreciated that the invention is not limited thereto.

The <100> single-crystal rod of a particular metal formed by mechanical processing is welded to the filament (e.g., tungsten filament) for heating heater.

Both ends of the filament can perform Joule heating by application of current via two conductive terminals brazed to the electrical porcelain. Subsequently, a sharpened tip having a curvature radius of several submicrons to several microns is formed on one end of the single-crystal rod by electrolytic polishing using aqueous sodium hydroxide solution.

The method of producing such a <100> single-crystal rod of a particular metal is described, for example in Japanese Patent No. 3250724. It is prepared, for example, by connecting a tungsten filament to the conductive terminal brazed to the electrical porcelain by spot welding, connecting a needle obtained by cutting a thin wire of the <100> single crystal metal to the filament by spot welding, and additionally electrolytically polishing the tip of the needle to an curvature radius of approximately 1 $\mu$m.

Then, a diffusion source is formed on part (preferably on the central region) of the single-crystal rod, by coating and drying thereon the slurry of the mixed metal oxide of barium oxide group and scandium oxide described above dispersed in an organic solvent such as isoamyl acetate, which is prepared by crushing and mixing the oxides in a mortar.

The electron source having the diffusion source formed thereon is placed in a vacuum apparatus, which is evacuated into vacuum state ($10^{-10}$ to $10^{-9}$ Torr), and the single-crystal rod is heated to a temperature of about 1400K to 1600K by application of current via the conductive terminals.

High electric field is then applied to the sharpened tip of the rod by application of negative high voltage to the single-crystal rod, and the {100} crystal face of the sharpened tip is exposed, as the rod was kept under the state. In this way, the work function declines only in the exposed area to be lower than that of the metal of the single-crystal rod, enabling electron emission at high current density.

The operating temperature of the electron source of 900K or more and 1250K or less is lower than the operating temperature of ZrO/W electron sources of 1800K, indicating that the electron source can emit electron beam at low energy width. The operating temperature is more favorably 1050K to 1150K.

The electron source according to the present invention and the electron-source rod for use therein have a diffusion source of a mixed metal oxide consisting of barium oxide group and scandium oxide, which is prepared as the molar ratio (compositional rate) of barium oxide group to scandium oxide is adjusted in a particular range, that can emit electrons at a temperature significantly lower than that of conventional ZrO/w electron sources. In addition, the electron source according to the present invention is superior in that it can emit electrons at lower temperature and for an extended period of time, even when compared to $BaAl_2O_4$ and $Pr_2O_3$ electron sources that are superior to ZrO/W electron sources. Further, the electron source can operate consistently at higher angular current density for a prolonged period of time. Thus, an electron source emitting electron beam at low energy width can be provided.

It is thus possible with an electronic device (electron beam-emitting device) using the electron source according to the present invention to obtain advantages traditionally unavailable in conventional devices. Examples of such electronic devices include scanning electron microscopes, transmission electron microscopes, surface analyzers such as Auger electron spectrometers, semiconductor-processing electron-beam devices, and electron-beam exposure devices. More specifically, it is possible by using the electron source according to the present invention to improve the resolution of scanning electron microscopes, transmission electron microscopes, surface analyzers and semiconductor-processing electron-beam devices and to draw more microscopic patterns in electron-beam exposure devices.

Hereinafter, the present invention will be described more in detail with reference to examples, but it should be understood that the present invention is not restricted by these Examples at all.

Examples

(Example 1)

Example 1 of the present invention will be described in detail with reference to drawings and tables.

Fig. 1 is a view illustrating the configuration of the electron source of the present Example. The electron source has an electrical porcelain 5, two conductive terminals 4 connected to the electrical porcelain 5, a filament 3 formed as it is connected to the conductive terminals 4, a rod 1 connected to the filament 3 and a diffusion source 2 formed on the central region of the rod.

Hereinafter, the method of producing the electron source according to the present invention will be described in detail.

The rod 1 is made of tungsten <100> single crystal, which has an electron-emitting face exposing the {100} crystal face in the tip region of the rod 1, and the diffusion source 2 is an electron source of a mixed oxide of barium and scandium oxides. The filament 3 is made of tungsten.

The rod 1 is welded to the filament 3. Both terminals of the filament 3 are fixed to the two conductive terminals 4, which are brazed to the electrical porcelain 5. The rod 1 is heated by Joule heating, by application of current via the conductive terminals 4 and the filament 3. A sharpened tip having a curvature radius of approximately 1 $\mu$m (not shown in the Figure) is formed as the tip of the rod 1 by electrolytic polishing using aqueous sodium hydroxide solution.

The diffusion source 2 is prepared by mixing barium carbonate ($BaCO_3$) and scandium oxide ($Sc_2O_3$) at a molar ratio of 3:2 and heating it in air at 1200°C for 50 hours, to give a sintered mixed oxide, crushing, mixing and dispersing it in a mortar by using isoamyl acetate as the dispersion medium, and coating and drying the slurry on the central region of the rod 1 (see Fig. 2).

The diffusion source 2 is sintered, as the electron source is placed in an environment at a vacuum of $10^{-10}$ Torr and the rod 1 is heated at a temperature of about 1500K for several minutes by application of current through the conductive terminals 4. The temperature of the rod 1 is then adjusted in the range of 900K to 1250K.

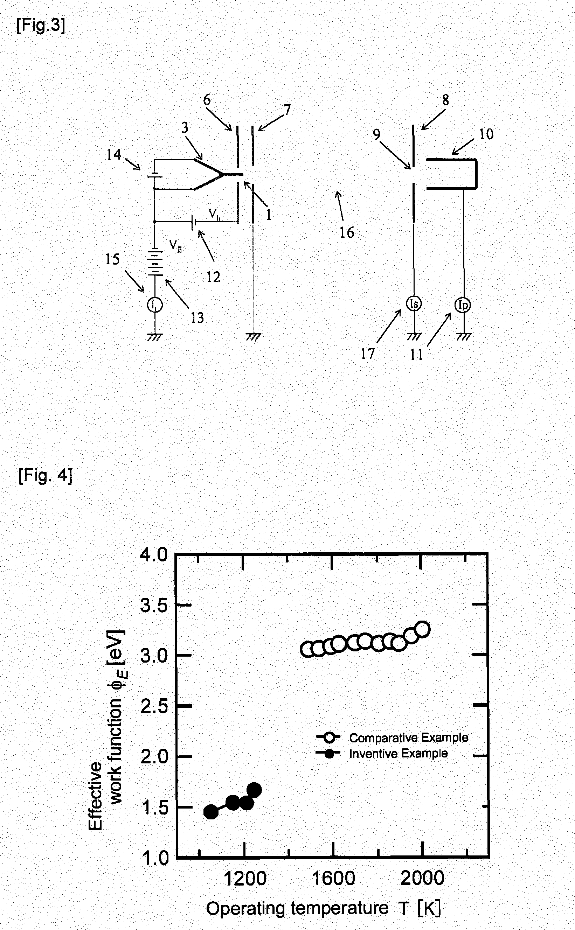

Fig. 3 is a schematic view of the electron source after the isoamyl acetate contained in the slurry is removed by vaporization, as it is installed in an instrument for evaluation of electron-emitting properties.

The tip of the rod 1 is placed between a suppressor electrode 6 and an extraction electrode 7. The distance between the tip of rod 1 and the suppressor electrode 6 is 0.25 mm, the distance between the suppressor electrode 6 and the extraction electrode 7 is 0.6 mm, and the extraction electrode 7 has a hole having a diameter of 0.6 mm, and the suppressor electrode 6 has a hole having a diameter of 0.4 mm.

The filament 3 is connected to a filament-heating power source 14, which is connected to a high-voltage power source 13, and a negative high voltage, i.e., emitter voltage $V_E$, is applied to the rod 1 and the filament 3. The suppressor electrode 6 is connected to a bias power source 12, and an additional negative voltage, bias voltage $V_b$, is applied to the rod 1 and the filament 3, thus blocking the thermal electrons emitted from the filament 3. Total radiation current It from the electron source is determined by an ammeter 15 placed between the high-voltage power source 13 and the ground. The electron beam 16 emitted from the tip of rod 1 passes through the hole of the extraction electrode 7 onto a fluorescent plate 8. The current Is that reached the fluorescent plate 8 (hereinafter, referred to as screen current) is determined by an ammeter 17. The fluorescent plate 8 has an aperture 9 (small hole) at the center and the probe current Ip that reached a cup-shaped electrode 10 through the aperture 9 is determined by a microammeter 11. When the solid angle, which is calculated from the distance between the aperture 9 and the tip of rod 1 and the internal diameter of the aperture 9, is designated as $\omega$, the angular current density is defined as $I_p/\omega$.

The surface of the tip of rod 1 is cleaned as the rod is heated to 1800K approximately for 1 minute; after readjustment of the temperature to 1100K, a bias voltage ($V_b$=-300 V) is applied to the suppressor electrode 6; and then, high emitter voltage ($V_E$=-6.0 kV) is applied thereto continuously for several hours to several tens of hours.

Total current generated increased gradually during the storage period and, when electron emission was continued for several hours at an emitter voltage lowered to -4.5 kV, only the central region of the fluorescent plate 8 became bright, confirming that the electron emission angle distribution is confined into a narrow region around its axis. The test was repeated 10 times. All fluorescent plates 8 became bright at the center, showing that the electron emission angle distribution was confined into a narrow region around its axis.

In addition, the temperature region in which the device operated reliably was determined at various operating temperatures and the relationship between screen current Is and angular current density $I_p/\omega$ to emitter voltage, i.e., current-voltage characteristics was determined. The bias voltage $V_b$ used in measurement of the current-voltage characteristics was 1/10 of the emitter voltage $V_E$.


(Examples 2 and 3)


The electron source used in Example 2 was similar to that used in Example 1, except that the materials constituting the diffusion source 2 of Example 1 were used at the rate shown in Table 1. Alternatively, the electron source used in Example 3 is identical with that used in Example 3 in the rate of the constituent materials for the diffusion source 2, but the raw material for the rod was molybdenum.

As shown in Table 1, when the mixed oxide constituting the diffusion source 2 is a mixed barium/scandium oxide at a component ratio of 1:1, the stabilized low-temperature operating range was 900K and the high-temperature operating range was 1250K. The electron emission distribution pattern at the center of the fluorescent plate was analyzed for evaluation of stabilized operating range and the minimum temperature at which the drift of the probe current Ip was 5% or less in 10 hours was used as the stabilized low-temperature operating range, while the maximum temperature as the stabilized high-temperature operating range. The test was also repeated 10 times, and all fluorescent plates 8 became bright only at the center, showing that the electron emission angle distribution was confined into a narrow region around its axis.

[Table 1]

| | | Rod | Constituent materials for diffusion source (molar ratio) | Stabilized low-temperature operating range | Stabilized high-temperature operating range | Operating temperature and period | Rate of confinement |
|---|---|---|---|---|---|---|---|
| Example | 1 | Tungsten | $BaO:Sc_2O_3 = 3:2$ | 900 K | 1250 K | 1100 K, 1600 Hr or more | 10/10 |
| | 2 | Tungsten | $BaO:Sc_2O_3 = 1:1$ | ditto | ditto | 1100 K, 1000 Hr or more | 10/10 |
| | 3 | Molybdenum | $BaO:Sc_2O_3 = 1:1$ | ditto | ditto | 1100 K, 1000 Hr or more | 10/10 |
| Comparative Example | 1 | Tungsten | ZrO | 1650 K | 1850 K | - | 10/10 |
| Test Example | 1 | Tungsten | $BaO:Sc_2O_3 = 2:3$ | 900 K | 1250 K | 1100 K, 150 Hr | 3/10 |
| | 2 | Tungsten | $BaO:Sc_2O_3 = 1:4$ | ditto | ditto | 1100 K, 200 Hr | 4/10 |
| | 3 | Tungsten | $BaO:CaO:Al_2O_3 = 6:1:2$ | ditto | ditto | 1150 K, 1600 Hr or more | 8/10 |
| Reference Example | 1 | Tungsten | $BaAl_2O_4$ | - | - | 1100 K, 200 Hr or more | - |
| | 2 | Tungsten | $Pr_2O_3$ | 1200 K | 1500 K | - | - |

(Test Examples 1 to 3)

The electron source used in Test Examples 1 and 2 was similar to that used in Example 1, except that the materials constituting the diffusion source 2 in Examples 1 and 2 were used at the rate shown in Table 1. Alternatively in the electron source used in Test Example 4, the mixed oxide constituting the diffusion source 2 was a mixed oxide containing barium oxide, calcium oxide and aluminum oxide at a component ratio (molar ratio) of 6:1:2.

The stabilized low-temperature operating range of the electron source in the Test Examples 1 to 3 was 900K and the high-temperature operating range was 1250K. The test was repeated 10 times, and in three electron sources in Example 1, four in Example 2 and eight in Example 3, the fluorescent plates 8 became bright only at the center, indicating that the electron emission angle distribution was confined into a narrow region around its axis.

(Comparative Example 1)

Comparative Example 1 is identical with Example 1, except that the diffusion source used was ZrO. The stabilized low-temperature operating range of the electron source in Comparative Example 1 was 1650K and the high-temperature' operating range thereof was 1850K. The electron source of Example 1 was found to operate reliably in a temperature range lower than that in Comparative Examples (between 900K and 1250K). It was also possible to improve the resolution of scanning electron microscopes and semiconductor-processing devices by using the electron source of Example 1 than by using a ZrO/W electron source.

The temperature dependence of the effective work functions of the electron sources of Example 1 and Comparative Example 1 is shown in Fig. 4. It was confirmed that the electron source of Example 1 containing a diffusion source of mixed barium and scandium oxides has an effective work function far lower than that of the ZrO/W electron sources.

(Reference Examples 1 and 2)

Table 1 shows the operating temperature and operating time of a barium-aluminate described in Patent Document 1 (Japanese Unexamined Patent Application Publication No. 2005-24515) (Example 3: negative voltage applied) as Reference Example 1 and also the stabilized low-temperature and high-temperature regions of $Pr_2O_3$ described in Patent Document 2 (Japanese Unexamined Patent Application Publication No. 2008-98087) as Reference Example 2. The table shows that the electron sources of Examples 1 to 3 can operate longer than the electron source of Reference Example 1. It also shows that it can operate at an operating temperature lower than that of Reference Example 2. Thus, the electron sources of Examples 1 to 3 are favorable electron sources that can operate at lower operating temperature for an extended period of time.

The method used for determining the effective work function will be described below.

The diameter of the {100} crystal face formed on the tip of rod 1 is analyzed by observation under a scanning electron microscope. The crystal face corresponds to the electron-emitting face, and the current density J is calculated by dividing the screen current $I_s$ by n (radius)$^2$. (Logarithm of current density J) is plotted against (absolute value of emitter voltage) $^{1/2}$ at each operating temperature; a regression line is obtained; and the current density at zero electric field (saturated current density) is calculated by zero extrapolation of the (absolute value of emitter voltage)$^{1/2}$.

The relationship among saturated current density J, operating temperature T and work function $\varphi$ can be defined by the following formula, based on the Richardson's Formula (S. G. Christov, Phys. Stat. Sol. 17, 11, 1966, p.22).

$$J = AT^2 \exp\left(-\varphi/k_B T\right)$$

wherein, J is saturated current density, $k_B$ is Boltzmann constant, $\varphi$ is work function, and T is absolute temperature.

If the work function when the Richardson constant A is the theoretical value of $120 A/cm^2/K^2$ is defined as effective work function $\varphi E$,

$$\varphi_E = -k_B T \cdot \ln\left(J/120 T^2\right)$$

The effective work function $\varphi_E$ is determined from the saturated current density J and the operating temperature T.

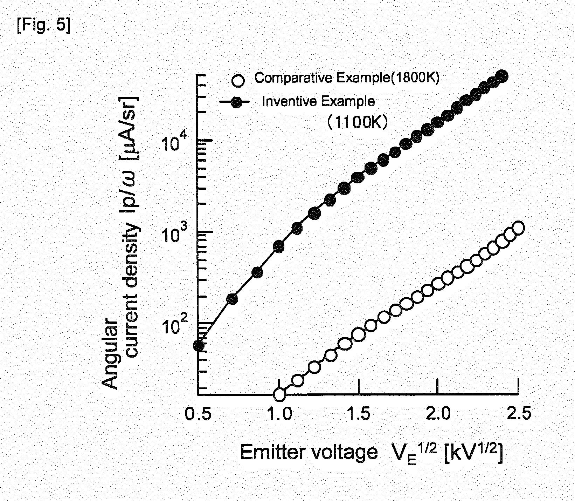

Fig. 5 shows the relationship between the angular current density $I_p/\omega$ and the emitter voltage of a ZrO/W electron source and an electron source of Example 1 having a diffusion source of the mixed barium and scandium oxides. The electron source of the Example showed an angular current density higher than that of the ZrO/W electron sources, showing that it is superior in performance as an electron source.

(Examples 2 and 3 and Test Examples 1 to 3)

The electron source of Example 2 is identical with that of Example 1, except that the materials constituting the diffusion source 2 of Example 1 were used at the rate shown in Table 1. Alternatively, the electron source of Example 3 is identical with that of Example 3 in the rate of the materials constituting the diffusion source 2, but the raw material for the rod was molybdenum.

The electron sources of Test Examples 1 and 2 are identical with that of Example 1, except that the materials constituting the diffusion source 2 of Examples 1 and 2 were used at the rate shown in Table 1.

In addition, the mixed oxide constituting the diffusion source 2 used in the electron source of Example 3 was a mixture of barium oxide, calcium oxide and aluminum oxide at a component ratio (molar ratio) of 6:1:2.

As shown in Table 1, these electron sources were found to operate longer than other oxide-based electron sources in long-term operation tests. Although the data are not shown in the table, these electron sources of Examples 1 and 2 were improved in resolution by about 40%, compared to the ZrO/W electron sources, when the electron sources were operated at 1100K as installed in a scanning electron microscope and analyzed at an accelerating voltage of 1 kV.

Reference Signs List

1:    Rod
2:    Diffusion source
3:    Filament
4:    Conductive terminal
5:    Electrical porcelain
6:    Suppressor electrode
7:    Extraction electrode

8:   Fluorescent plate
9:   Aperture
10:  Cup-shaped electrode
11:  Microammeter for measurement of probe current
12:  Bias power source
13:  High-voltage power source
14:  Filament-heating power source
15:  Ammeter for measurement of total current generated
16:  Electron beam emitted
17:  Microammeter for measurement of screen current

**Claims**

1.  An electron source, comprising
    an electrical porcelain,
    two conductive terminals connected to the electrical porcelain,
    a filament formed as it extends between the conductive terminals,
    and
    a rod of the <100> single crystal of at least one metal selected from the group consisting of tungsten, molybdenum, tantalum and rhenium, connected to the filament, wherein:

    the rod has an electron-emitting face formed in a tip region with its {100} crystal face exposed;
    the rod has a diffusion source on a central region;
    the diffusion source is made of a mixed oxide of barium oxide group and scandium oxide; and
    a compositional rate of barium oxide group as BaO is 50 mol % or more and a compositional rate of scandium oxide as $Sc_2O_3$ is 10 to 50 mol % when the mixed oxide is prepared.

2.  The electron source according to Claim 1, wherein an operating temperature thereof is 900K or more and 1250K or less.

3.  The electron source according to Claim 1, wherein the barium oxide group is $BaCO_3$.

4.  An electron-source rod, formed with the <100> single crystal of at least one metal selected from the group consisting of tungsten, molybdenum, tantalum and rhenium, comprising
    an electron-emitting face exposing the {100} crystal face in the tip re gion and
    a diffusion source of a mixed oxide prepared by heat treatment of a mixture containing barium oxide group and scandium oxide at a molar ratio of barium oxide group (as BaO): scandium oxide (as $Sc_2O_3$) of 1:1 to 3:2 on a central region of the rod.

5.  The electron-source rod according to Claim 4, wherein the mixture contains the barium oxide group and the scandium oxide at a barium oxide group compositional rate of 50 to 90 mol % (as BaO) and a scandium oxide compositional rate of 10 to 50 mol % (as $Sc_2O_3$) with respect to 100 mol % of the sum of the amounts as BaO and $Sc_2O_3$.

6.  The electron-source rod according to Claim 5, wherein an operating temperature is 900K or more an 1250K or less.

7.  An electronic device, comprising an electron source containing the electron source according to Claim 1 or 2 or comprising the electron-source rod according to Claim 4.

[Fig.1]

[Fig. 2]

[Fig.3]

[Fig. 4]

[Fig. 5]

# INTERNATIONAL SEARCH REPORT

| International application No. |
| --- |
| PCT/JP2010/066534 |

**A. CLASSIFICATION OF SUBJECT MATTER**
*H01J1/304*(2006.01)i, *H01J37/073*(2006.01)i

According to International Patent Classification (IPC) or to both national classification and IPC

**B. FIELDS SEARCHED**

Minimum documentation searched (classification system followed by classification symbols)
H01J1/304, H01J37/073

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X<br>Y | JP 2004-265614 A (Denki Kagaku Kogyo Kabushiki Kaisha),<br>24 September 2004 (24.09.2004),<br>claim 3; paragraphs [0001], [0028] to [0039], [0043]; fig. 1<br>& JP 2005-222945 A     & US 2006/0076866 A1<br>& EP 1592040 A1     & WO 2004/070766 A1 | 1-2,4-7<br>3 |
| Y | JP 01-102829 A (Hitachi, Ltd.),<br>20 April 1989 (20.04.1989),<br>page 2, lower left column, line 18 to page 2, lower right column, line 13<br>(Family: none) | 3 |

| | Further documents are listed in the continuation of Box C. | | See patent family annex. |
| --- | --- | --- | --- |

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search<br>13 October, 2010 (13.10.10) | Date of mailing of the international search report<br>26 October, 2010 (26.10.10) |
| --- | --- |
| Name and mailing address of the ISA/<br>Japanese Patent Office | Authorized officer |
| Facsimile No. | Telephone No. |

Form PCT/ISA/210 (second sheet) (July 2009)

## INTERNATIONAL SEARCH REPORT

| International application No. |
| --- |
| PCT/JP2010/066534 |

**Box No. II    Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III    Observations where unity of invention is lacking (Continuation of item 3 of first sheet)**

This International Searching Authority found multiple inventions in this international application, as follows:
  See extra sheet.

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**        ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

**INTERNATIONAL SEARCH REPORT**

International application No.

PCT/JP2010/066534

Continuation of Box No.III of continuation of first sheet(2)

This patent application contains two inventions failing to comply with the requirement of unity of invention, as will be described in the following.

Document 1: JP 2004-265614 A (Denki Kagaku Kogyo Kabushiki Kaisha), 24 September 2004 (24.09.2004), [claim 3], [0001], [0028]-[0039], [0043], fig. 1, & JP 2005-222945 A, & US 2006/0076866 A1, & EP 1592040 A1, & WO 2004/070766 A1

Document 1 discloses an electron source:
(1) comprising an insulating glass, a conductive terminal soldered to said insulating glass, a filament fixed on said conductive terminal, and a needle attached to said filament,
(2) wherein said needle is made of single crystal tungsten of a <100> azimuth and having a flat surface made of a (100) crystal plane at the tip thereof, and
(3) wherein said needle has a supply source made of $BaSc_2O_4$;
    and an electron device using said electron source.
    It is admitted from the composition that the $BaSc_2O_4$ has been prepared by mixing a barium compound and a scandium compound at a molar ratio of 1 : 1 by converting the same into $BaO$ and $Sc_2O_3$ (that is, a molar ratio of 50 mol% for both the both compounds).

Thus, the invention of claims 1, 4-5 and 7 is not admitted to involve any novelty to and any special technical feature over the invention disclosed in document 1. If the special technical features are determined on the claims dependent on claim 1, therefore, these claims contain the two inventions. These individual inventions have the following special technical features.
    Here, the inventions of claims 1, 4-5 and 7 but without any special technical feature are grouped into invention 1. On the other hand, the matter of claim 2 or 6 is sorted into invention 1, since it is a mere matter of design variation for the invention disclosed in document 1 but does not have any special technical feature.

(Invention 1)    Invention of claims 1-2 and 4-7
    Invention of claims 1-2 and 4-7 but without any special technical feature.
(Invention 2)    Invention of claim 3
    Invention having the matter of claim 3 as a special technical feature.

Form PCT/ISA/210 (extra sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005222945 A
- JP 2008098087 A
- JP 3250724 B
- JP 2005024515 A

**Non-patent literature cited in the description**

- **J. PAWLEY.** *Journal of Microscopy,* 1984, vol. 136, 45
- **R. D. YOUNG.** *Phys. Rev.,* 1959, vol. 113, 110
- **S. G. CHRISTOV.** *Phys. Stat. Sol.,* 1966, vol. 17 (11), 22